# FASCICULE DE BREVET EUROPEEN

(11) **EP 1 994 580 B1**
(45) Date de publication et mention de la délivrance du brevet: **02.05.2012**
(21) Numéro de dépôt: 07731064.7
(22) Date de dépôt: 28.02.2007
(51) Int. Cl.: H01L 51/50

(54) **COMPOSANT ÉLECTRONIQUE À SEMI-CONDUCTEUR ORGANIQUE DOPÉ P.**
ELEKTRONISCHE KOMPONENTE MIT P-DOTIERTEM ORGANISCHEM HALBLEITER
ELECTRONIC COMPONENT COMPRISING A P-DOPED ORGANIC SEMICONDUCTOR

(30) Priorité: 28.02.2006 FR 0650683
(43) Date de publication de la demande: 26.11.2008
(73) Titulaire: Commissariat à l'Énergie Atomique et aux Énergies Alternatives, 75015 Paris (FR)
(72) Inventeur: BEN KHALIFA, Mohamed, I-73010 Amesano (IT); VAUFREY, David, F-38000 Grenoble (FR)
(74) Mandataire: Hecké, Gérard
(86) Numéro de dépôt international: PCT/FR2007/000363
(87) Numéro de publication internationale: WO 2007/099229

(56) Documents cités:
- WO-A-2006/056586
- US-A- 5 093 698
- US-A- 5 942 374
- US-A1- 2005 110 009
- US-A1- 2005 170 211
- US-B1- 6 525 465

## Description

### Domaine technique de l'invention

L'invention concerne le dopage p de matériaux semiconducteurs organiques à base, notamment, de petites molécules (par opposition aux polymères), et l'utilisation de ces semi-conducteurs dopés, notamment, pour des diodes électroluminescentes, des transistors organiques, ou pour tout autre composant électronique. Les dopants p sont des dopants accepteurs d'électrons ; ils sont donc généralement oxydants vis-à-vis du matériau qu'ils dopent.

### Etat de la technique

La fabrication de transistors ou de diodes à semiconducteur organique à base de petites molécules passe généralement par une étape de dépôt sous vide sur un substrat généralement préalablement doté d'une électrode ou plusieurs électrodes dites inférieures ; lors de cette étape, on évapore la molécule du semiconducteur dans une enceinte sous vide, de manière à ce qu'elle se re-condense sur ce substrat pour former une couche de dépôt ; on dépose ensuite généralement une ou plusieurs électrodes dites supérieures sur la couche organique.

Le document US 6525465 se rapporte à des diodes électroluminescentes organiques dans lesquelles un film mince isolant est agencé entre la cathode et la couche organique pour faciliter l'injection des électrons depuis la cathode.

Les matériaux semiconducteurs organiques des couches organiques ainsi déposées sont parfois dopés n ou p, de manière à augmenter la densité de charges, électrons ou trous, qui participent à la conduction électrique de ces couches. Dans le cas des transistors, le dopage est aussi le moyen de réaliser des contacts drain (ou source) - semiconducteur organique ayant de très faibles barrières énergétiques. Dans le cas de diodes, ce dopage n ou p permet notamment d'augmenter la densité de charges pour le transport des électrons ou des trous, et d'abaisser ainsi les pertes ohmiques. Pour l'obtention de couches dopées, le dépôt est alors généralement effectué par co-évaporation sous vide du matériau organique semiconducteur et du dopant.

Les diodes organiques électroluminescentes comprennent généralement une couche organique électroluminescente intercalée entre une anode et une cathode ; pour faciliter l'injection des trous par l'anode et le transport de ces trous jusqu'à la couche organique électroluminescente, il est connu d'intercaler, entre cette dernière couche et l'anode, une couche dite de transport de trous en matériau organique semiconducteur dopé p ; symétriquement, pour faciliter l'injection des électrons par la cathode et le transport de ces électrons jusqu'à la couche organique électroluminescente, il est connu d'intercaler, entre cette dernière couche et la cathode, une couche dite de transport d'électrons en matériau organique semiconducteur dopé n. Les documents US5093698, US6566807, WO2003/083958 et US2004/062949 décrivent de telles diodes. Ces couches dopées peuvent elles-mêmes servir d'électrodes comme décrit dans le document US6433355 ; le document US6639357 décrit le cas d'une cathode en matériau organique semiconducteur qui est dopé n notamment par du lithium ou du strontium.

Puisque le dopage n ou p des couches de transport permet d'obtenir des couches de transport de conductivité élevée, on limite les pertes ohmiques et on peut utiliser des couches de transport plus épaisses mieux adaptées à un taux élevé d'extraction de lumière par effet de cavité optique résonnante entre les électrodes.

Il convient également que le matériau de ces couches de transport soit adapté au matériau de l'électrode, anode ou cathode, avec laquelle elles sont en contact de manière à limiter la barrière de potentiel éventuelle à l'interface.

Le matériau généralement utilisé pour les cathodes est choisi parmi les matériaux qui présentent un faible potentiel d'ionisation, généralement inférieur ou égal à 3 eV ; le matériau semiconducteur généralement utilisé pour la couche de transport d'électrons est choisi parmi les matériaux dont l'énergie du niveau du LUMO (« Lowest Unoccupied Molecular Orbital ») est voisine, de préférence supérieure (valeur absolue), au potentiel d'ionisation du matériau de la cathode ; le dopage n de ce semi-conducteur, en créant une jonction de type Schottky à l'interface avec la cathode, permet d'utiliser des matériaux semiconducteurs ayant une énergie de niveau de LUMO inférieure (valeur absolue) au potentiel d'ionisation du matériau de la cathode ; le niveau du dopage de type n est alors adapté d'une manière connue en elle-même à la hauteur de la barrière de potentiel que les électrons doivent pouvoir franchir à l'interface avec la cathode ; pour obtenir un dopage n efficace, il convient que le dopant n, qui est donneur d'électrons, présente un travail de sortie (ou une énergie du niveau du HOMO dans le cas d'un dopant organique) supérieur à l'énergie du niveau de LUMO du matériau semi-conducteur de la couche de transport d'électrons, et, de préférence inférieur au travail de sortie du matériau de la cathode. Ainsi, le document US6013384 fixe à 4,2 eV la limite supérieure du travail de sortie pour les dopants n des couches de transport d'électrons. Ce document US6013384 décrit une diode organique électroluminescente comprenant une anode, une cathode, une couche organique électroluminescente qui est intercalée entre cette anode et cette cathode, une couche d'un matériau organique semiconducteur dopé n à l'aide d'un dopant donneur, qui est intercalée entre cette couche organique électroluminescente et cette cathode, où le dopant donneur est choisi dans le groupe formé par les éléments alcalins, les éléments alcalino-terreux, les métaux de transition et les terres rares qui présentent un travail de sortie qui est, en valeur absolue, inférieur ou égal à 4,2 eV.

Le matériau généralement utilisé pour les anodes est choisi parmi les matériaux qui présentent un fort potentiel d'ionisation, généralement supérieur ou égal à 4 eV ; le matériau semiconducteur généralement utilisé pour la couche de transport de trous est choisi parmi les matériaux dont l'énergie du niveau du HOMO (« Highest Occupied Molecular Orbital ») est voisine, de préférence inférieure (valeur absolue), au potentiel d'ionisation du matériau de la cathode ; le dopage p de ce semi-conducteur, en créant une jonction de type Schottky à l'interface avec l'anode, permet d'utiliser des matériaux semiconducteurs ayant une énergie de niveau de HOMO supérieure (valeur absolue) au potentiel d'ionisation du matériau de l'anode ; le niveau du dopage p est alors adapté d'une manière connue en elle-même à la hauteur de la barrière de potentiel que les trous doivent pouvoir franchir à l'interface avec l'anode ; pour obtenir un dopage p efficace, il convient que le dopant p, qui est accepteur d'électrons, présente un travail de sortie, ou une énergie du niveau de LUMO dans le cas d'un dopant organique, qui est inférieure à l'énergie du niveau du HOMO du matériau semi-conducteur de la couche de transport de trous, et de préférence supérieure au travail de sortie du matériau de l'anode. Les dopants p qui conviennent habituellement sont généralement des dopants organiques, comme le F4-TCNQ ; ces dopants organiques p sont généralement toxiques.

### Objet de l'invention

Un but de l'invention est d'offrir une alternative aux dopants organiques de type p, notamment pour limiter les problèmes de toxicité.

La diode électroluminescent organique selon l'invention comprend une couche d'injection et de transport de trous en matériau organique semiconducteur à base de petites molécules dopée de type p, caractérisée en ce que ledit dopant est choisi dans le groupe formé par le bore, le carbone, le silicium, le cobalt, le nickel, le cuivre, le germanium, le rhodium, le palladium, l'antimoine.

La couche en matériau organique semiconducteur qui est dopé p sert à l'injection et au transport des trous à partir de l'anode vers une couche organique électroluminescente de cette diode.

Dans le cas notamment où le matériau de l'anode est l'ITO (« Indium Tin Oxide » en langue anglaise), dont la fonction de travail est de l'ordre de 4,7 eV, le dopant accepteur présente une fonction de travail supérieure ou égale à 4,7 eV.

De préférence, la concentration dudit dopant accepteur dans ledit matériau organique semiconducteur est adaptée pour que la conductivité dudit matériau soit supérieure à 10-7 S/cm. Cette concentration correspond généralement à un dopage de type p suffisamment significatif, et non pas fortuit.

L'obtention de conductivité supérieure à 10⁻⁷ S/cm nécessite l'introduction dans l'intervalle de rapport molaire dopant par rapport au semiconducteur organique entre 1/1000 et 10/1 selon la conductivité souhaitée et la nature du couple dopant - semiconducteur organique.

Ledit dopant est choisi dans le groupe formé par le bore, le carbone, le silicium, le cobalt, le nickel, le cuivre, le germanium, le rhodium, le palladium, l'antimoine. Ces éléments présentent avantageusement à la fois une toxicité et une température d'évaporation sous vide qui ne sont pas pratiquement rédhibitoires.

La diode organique électroluminescente comprend une anode, une cathode, une couche organique électroluminescente qui est intercalée entre cette anode et cette cathode. La couche additionnelle en matériau organique semiconducteur dopé p est avantageusement intercalée entre cette couche organique électroluminescente et l'anode. La couche dopée p sert donc ici à l'injection et au transport de trous de l'anode dans la couche organique électroluminescente.

De préférence, l'épaisseur de ladite couche en matériau organique semiconducteur dopé p est supérieure ou égale à 30 nm. Si la couche de transport de trous comprend une partie dopée p et une partie non dopée, on ne prend en compte ici que l'épaisseur de la partie dopée. L'épaisseur de cette couche est de préférence inférieure ou égale à 100 nm, notamment pour limiter les pertes ohmiques dans la diode.

### Description détaillée de l'invention

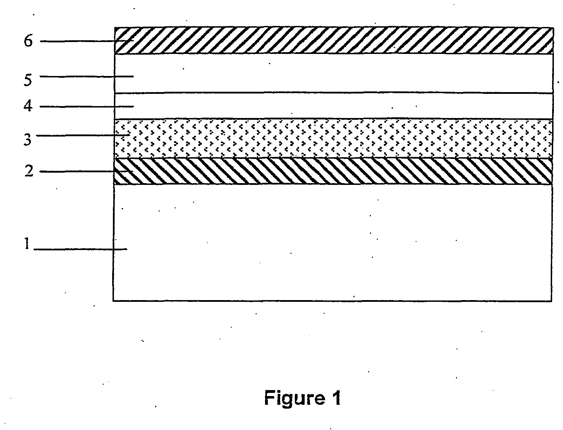

L'invention sera mieux comprise à la lecture de la description qui va suivre, donnée à titre d'exemple non limitatif en référence à la figure 1 annexée, qui représente une structure de diode organique électroluminescente selon un mode de réalisation de l'invention.

En référence à la figure 1, on dépose une anode 2 sur un substrat isolant 1. L'anode est par exemple en ITO, dont le travail de sortie vaut 4,7 eV ; on procède d'une manière classique, par exemple par pulvérisation cathodique sous vide.

On dépose ensuite une couche 3 en matériau organique semiconducteur dopé p destinée à servir au transport de trous. Le dépôt est effectué par co-évaporation sous vide de ce matériau semiconducteur organique et du dopant p qui est ici un élément chimique inorganique dont le potentiel d'ionisation est supérieur ou égal à 4,7 eV ; on utilise par exemple le cobalt, le nickel,; contrairement au dopage p décrit dans les documents EP0948063 et US4481132, le produit qui est co-déposé avec le semiconducteur n'est donc pas un sel d'élément chimique inorganique, ni un acide de Lewis ; le degré d'oxydation de l'élément co-déposé est donc ici égal à zéro, alors qu'il est généralement supérieur à zéro lorsqu'on utilise un sel ou un acide de Lewis.

On dépose ensuite d'une manière connue en elle-même, une couche organique électroluminescente 4, une couche de transport d'électrons 5, et une cathode 6. Optionnellement, on peut ajouter une couche mince de blocage d'électrons entre la couche de transport de trous 3 et la couche organique électroluminescente 4, et/ou une couche mince de blocage de trous entre la couche organique électroluminescente 4 et la couche de transport d'électrons 5. Le matériau de la couche de blocage d'électrons peut être le même semi-conducteur, mais non dopé, que celui de la couche 3 en matériau organique semiconducteur dopé p. Les matériaux et l'épaisseur des couches 4, 5 et 6 sont connus en eux-mêmes et ne seront donc pas décrits ici en détail.

On obtient alors une diode organique électroluminescente selon l'invention, qui présente un bon rendement lumineux grâce à la présence de la couche en matériau organique semiconducteur dopé p de faible résistivité. Comme le dopant p est un élément atomique choisi de préférence dans le groupe formé par le bore, le carbone, le silicium, le cobalt, le nickel, le cuivre, le germanium, le rhodium, le palladium, l'antimoine le dopage p est efficace car ces éléments présentent un potentiel d'ionisation supérieur ou égal à 4,7 eV. Le dopage p n'est pas dangereux à mettre en oeuvre, car aucun de ces éléments n'est très toxique, et le dépôt par co-évaporation est possible car la température d'évaporation sous vide de ces éléments est suffisamment basse.

Le dopant est avantageusement un élément atomique, ayant une température d'évaporation inférieure à 1300°C pour une pression de 10-8 Torr.

Le platine et l'or ne sont pas adaptés pour constituer le dopant, étant donné que l'or est connu pour diffuser entre les couches, et le platine pour avoir une tempétature d'évaporation élevée.

Comme exemple spécifique de réalisation de cette diode selon l'invention, on peut citer l'empilement suivant : couche 2: ITO - couche 3 : NPB dopé Co - couche 4 : Alq3 - couche 5 : BPhen dopé Cs - couche 6 : aluminium ; en variante, on ajoute une couche de blocage d'électrons entre les couches 3 et 4 : NPB non dopé - et une couche de blocage de trous entre les couches 4 et 5 : BCP.

De préférence, la couche 3 en matériau organique semiconducteur dopé p présente une épaisseur supérieure ou égale à 30nm, de façon à pouvoir optimiser les effets de cavité dans la diode sans conséquences importantes sur la tension, étant donné la conductivité élevée de cette couche par rapport aux couches non dopées.

Il est parfois avantageux de ne doper la couche organique que sur une tranche, de manière à limiter la diffusion du dopant dans une couche active adjacente.

Une autre solution pour prévenir la diffusion des dopants dans la couche active, consisterait à introduire une seconde couche de nature différente non dopée, Cette seconde couche est adjacente à la couche organique dopée, mais aurait une épaisseur plus faible pour limiter les pertes ohmiques.

La présente invention a été décrite en se référant à une diode organique électroluminescente où l'anode est une électrode inférieure, et la cathode une électrode supérieure ; l'invention s'applique également aux diodes dont la cathode est une électrode inférieure et l'anode une électrode supérieure.

## Revendications

1. Diode électroluminescente organique comprenant une couche (3) d'injection et de transport de trous, en matériau organique semiconducteur à base de petites molécules, dopée de type p,
**caractérisée en ce que** ledit dopant est choisi dans le groupe formé par le bore, le carbone, le silicium, le cobalt, le nickel, le cuivre, le germanium, le rhodium, le palladium, l'antimoine.

2. Diode selon la revendication 1, **caractérisée en ce que** le rapport molaire entre le dopant et le matériau semi-conducteur organique peut varier entre 1/1000 et 10/1.

3. Diode selon la revendication 1 ou 2, **caractérisée en ce que** la couche en matériau organique semiconducteur dopé présente une épaisseur supérieure ou égale à 30nm.

4. Diode selon l'une des revendications 1 à 3, **caractérisée en ce que** la couche en matériau organique semiconducteur est pourvue d'une tranche non dopée.

5. Diode selon l'une des revendications 1 à 3, **caractérisée en ce que** la couche en matériau organique semiconducteur dopé est adjacente à une couche non dopée et d'épaisseur inférieure.

## Claims

1. An organic light-emitting diode comprising a layer (3) of holes injection and transport, said layer being comprised of small molecules based organic semiconducting material in which a p-dopant is dispersed,
**characterized in that** said dopant is chosen from the group formed by boron, carbon, silicon, cobalt, nickel, copper, germanium, rhodium, palladium, antimony.

2. The diode according to claim 1, **characterized in that** the molar ratio between the dopant and the organic semiconducting material can vary between 1/1000 and 10/1.

3. The diode according to claim 1 or 2, **characterized in that** the doped organic semiconducting material layer presents a thickness higher than or equal to 30nm.

4. The diode according to any claim 1 to 3, **characterized in that** the organic semiconducting material layer is provided with a non-doped edge.

5. The diode according to any claim 1 to 3, **characterized in that** the doped organic semiconducting material layer is adjacent to a non-doped layer of smaller thickness.

## Patentansprüche

1. P-dotierte organische Leuchtdiode aus halbleitendem organischen Material auf Basis kleiner Moleküle, die eine Injektions- und Lochleitungsschicht (3) umfasst,
**dadurch gekennzeichnet, dass** die Dotierungssubstanz aus der aus Bor, Kohlenstoff, Silizium, Kobalt, Nickel, Kupfer, Germanium, Rhodium, Palladium, Antimon gebildeten Gruppe ausgewählt ist.

2. Diode nach Anspruch 1, **dadurch gekennzeichnet, dass** das Molverhältnis zwischen der Dotierungssubstanz und dem halbleitenden organischen Material 1/1000 bis 10/1 betragen kann.

3. Diode nach Anspruch 1 oder 2, **dadurch gekennzeichnet, dass** die Schicht aus halbleitendem organischen dotierten Material eine Dicke von über oder gleich 30 nm hat.

4. Diode nach einem der Ansprüche 1 bis 3, **dadurch gekennzeichnet, dass** die Schicht aus halbleitendem organischen Material mit einer nichtdotierten Schicht versehen ist.

5. Diode nach einem der Ansprüche 1 bis 3, **dadurch gekennzeichnet, dass** die Schicht aus halbleitende organischen dotierten Material an eine nichtdotierte Schicht mit geringerer Dicke angrenzt.
